# EUROPÄISCHE PATENTSCHRIFT

(11) **EP 0 646 247 B1**
(45) Veröffentlichungstag und Bekanntmachung des Hinweises auf die Patenterteilung: **11.08.1999**
(21) Anmeldenummer: 94913549.5
(22) Anmeldetag: 12.04.1994
(51) Int. Cl.: G01R 15/14

(54) **KLEMME ZUR VERBINDUNG VON STROMFÜHRENDEN LEITERN**
TERMINAL FOR CONNECTING LIVE CONDUCTORS
BORNE POUR LA LIAISON DE FILS CONDUCTEURS

(30) Priorität: 20.04.1993 DE 4312760
(43) Veröffentlichungstag der Anmeldung: 05.04.1995
(73) Patentinhaber: LUST ANTRIEBSTECHNIK GmbH, 35633 Lahnau-Waldgirmes (DE)
(72) Erfinder: LUST, Karl-Heinz, D-35633 Lahnau-Waldgirmes (DE)
(74) Vertreter: Missling, Arne, Dipl.-Ing.
(86) Internationale Anmeldenummer: EP9401084
(87) Internationale Veröffentlichungsnummer: WO9424574

(56) Entgegenhaltungen:
- EP-A- 0 294 636
- FR-A- 2 590 028

## Beschreibung

Die Erfindung betrifft eine Klemme zur Verbindung von stromführenden Leitern mit mindestens zwei Klemmelementen für die elektrischen Leiter und einem die beiden Klemmelemente miteinander elektrisch verbindenden Verbindungsstück. Eine derartige Klemme zeigt die FR-A-2 590 028.

Die FR-A-2 590 028 zeigt ein Gehäuse mit zwei Klemmen, die über einen Shunt verbunden sind. An den Klemmen sind die elektrischen Stromleiter angeschlossen. Das Gerät dient zur automatischen Abschaltung angeschlossener Verbraucher unter Verwendung eines Transformators.

Die potentialfreie Erfassung von Gleich- und Wechselströmen wird nach Stand der Technik mit Stromsensoren auf Basis der Kompensation von in einem weichmagnetischen Kern geführten Magnetfeldern realisiert, die durch Hall-Elemente detektiert werden.

Neuere Entwicklungen nutzen magnetoresistive Sensoren zur Erfassung des Magnetfeldes. Magnetsensoren der vorstehend genannten Art sind zum Beispiel in der DE-43 00 605.1 beschrieben.

Der Erfindung liegt die Aufgabe zugrunde, eine Einrichtung zur Erfassung von Magnetfeldern vorzuschlagen, die einfach in ihrem Aufbau ist und in einfacher Art und Weise in räumlicher Nähe zu den Anschlußklemmen des Gerätes anzuordnen ist.

Die Aufgabe wird erfindungsgemäß dadurch gelöst, daß die Klemme einen oder mehrere Magnetfeldsensoren in einem vorgegebenen Abstand relativ zu dem Verbindungsstück aufweist, das die elektrische Verbindung der Klemmelemente herstellt.

Gemäß der Erfindung ist die Anschlußklemme, die in der Regel in räumlicher Nähe zu den Geräten angeordnet ist, mit einem oder mehreren Magnetfeldsensoren versehen, wobei diese Magnetfeldsensoren in einem bestimmten Abstand zum Verbindungsstück angeordnet sind, das die beiden anzuschließenden Leiter elektrisch miteinander verbindet. Hierdurch wird eine potentialfreie Erfassung der Geräteein- und -ausgangsströme sowie ein Verbindungselement zwischen der geräteinternen und der anwendungsspezifischen Externverkabelung geschaffen.

Vorteilhaft ist der bzw. die Magnetfeldsensoren auf einem Isolator befestigt, der wiederum am Verbindungsstück festgelegt ist. Hierdurch wird in einfachster Weise eine definierte Anordnung des Magnetfeldsensors zu den im Verbindungsstück fließenden Strömen geschaffen, so daß eine exakte potentialfreie Erfassung von Gleich- und Wechselströmen gewährleistet ist.

Gemäß einer weiteren Ausbildung der Erfindung ist zusätzlich zum Magnetfeldsensor eine Auswerteschaltung in der Klemme vorgesehen. Die Klemmen können mit Außenabmessungen in Normform hergestellt werden, so daß diese in bekannter Art und Weise auf Schienen, insbesondere auf Hutschienen, befestigbar sind.

Mit einer erfindungsgemäßen Klemme wird eine erhebliche Reduzierung der Bauteilekosten, ein erheblich reduzierter Montageaufwand, eine höhere Betriebssicherheit durch Reduzierung von Kontaktstellen, eine erhebliche Einsparung an Bauvolumen sowie eine Reduzierung der Beeinträchtigung der Meßsignale durch Einkoppeln von Fremdfeldern erreicht.

Ein Ausführungsbeispiel der Erfindung ist im folgenden anhand der Zeichnung näher beschrieben. In dieser zeigen:
- Fig. 1: eine erfindungsgemäß ausgebildete Klemme im Schnitt gemäß Linie II-II in Fig. 2,
- Fig. 2: eine Seitenansicht mehrerer nebeneinander angeordneter Klemmen,
- Fig. 3: das Verbindungsstück zwischen den Anschlußkontakten der Klemme in perspektivischer Ansicht und
- Fig. 4: eine Stirnansicht in Richtung des Pfeiles A in Fig. 3.

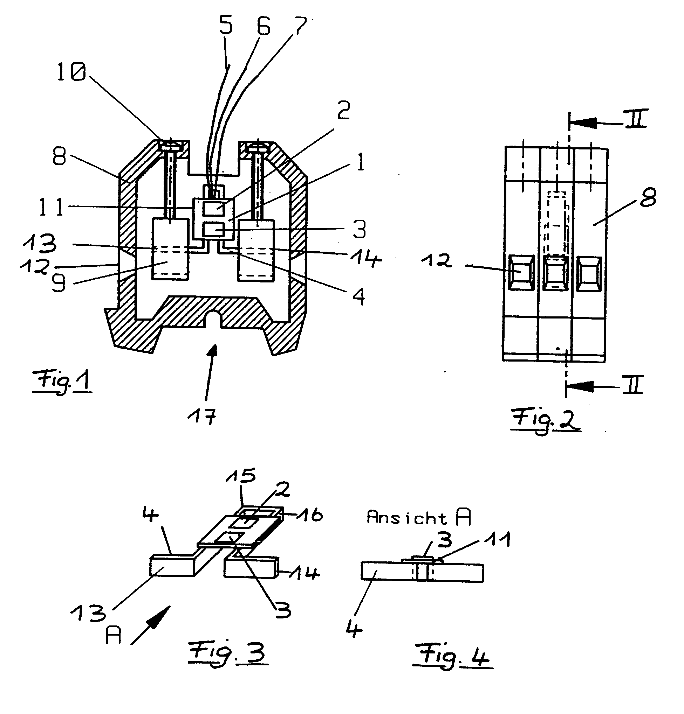

Die in den Fig. 1 und 2 dargestellte erfindungsgemäße Klemme besitzt ein Gehäuse 8, das stirnseitige Durchbrechungen 12 aufweist, durch die die zu verbindenden elektrischen Leiter in das Gehäuse 8 eingeschoben werden. Im Inneren des Gehäuses sind die Klemmelemente 9 für die Befestigung der elektrischen Leiter in bekannter Art und Weise angeordnet, wobei zum Festklemmen der Leiter in den Klemmelementen 9 Schrauben 10 dienen. Die beiden Klemmelemente 9 sind über ein Verbindungsstück 4 miteinander verbunden, das in den Fig. 3 und 4 im Detail dargestellt ist. Das Verbindungsstück 4 ist U-förmig gebogen und mit seinen beiden Enden 13, 14 in den Klemmelementen 9 befestigt. Auf den beiden Schenkeln 15, 16 des Verbindungsstückes 4 ist ein Isolator 11 befestigt, in dem eine Hybrid-Schaltung 1 für den Sensorchip 2 und die Auswerteschaltung 3 integriert ist.

Über Leitungen 5, 6 und 7 wird der Sensorchip sowie die Auswerteschaltung mit Spannung versorgt und die Meßdaten abgeführt.

Das Gehäuse 8 einer erfindungsgemäß ausgebildeten Klemme kann auf eine U- oder Hutschiene mit seinem Sockel 17 aufgeschoben werden, so daß, wie Fig. 2 zeigt, mehrere Klemmen nebeneinander angeordnet sind. Für bestimmte Anwendungsfälle ist es zweckmäßig, wenn die Verbindungsstücke 4 dieser Klemmen mit definierten, jedoch unterschiedlichen Widerständen ausgebildet sind.

So ist es für die Anwendung einer Spannungsmessung von Interesse, die betrachtete Spannungsquelle möglichst hochohmig zu belasten. um aus dem dann fließenden Strom rückwirkend die Spannung zu ermitteln.

Erweiterungen z. B. im Hinblick auf eine Leistungsmessung erfordern eine gleichzeitige Erfassung von angelegter Spannung und aufgenommenem Strom, so daß hierfür bereits zwei Klemmen, sinnvollerweise nebeneinander, anzuordnen sind.

## Patentansprüche

1. Klemme zur Verbindung von stromführenden Leitern mit mindestens zwei Klemmelementen (9) für die elektrischen Leiter und einem die Klemmelemente (9) elektrisch miteinander verbindenden Verbindungsstück (4), dadurch gekennzeichnet, daß die Klemme einen oder mehrere Magnetfeldsensoren (2) in einem vorgegebenen Abstand relativ zu dem Verbindungsstück (4) aufweist, das die elektrische Verbindung der Klemmelemente (9) herstellt.

2. Klemme nach Anspruch 1, dadurch gekennzeichnet, daß zwischen Verbindungsstück (4) und Magnetfeldsensor (2) ein oder mehrere Isolatoren (11) angeordnet sind.

3. Klemme nach Anspruch 1 oder 2, dadurch gekennzeichnet, daß die Isolatoren (11) die Magnetfeldsensoren (2) und das Verbindungsstück (4) miteinander verbinden.

4. Klemme nach einem der Ansprüche 1 bis 3, dadurch gekennzeichnet, daß zusätzlich zum Magnetfeldsensor (2) eine Auswertschaltung (3) in der Klemme vorgesehen ist.

5. Klemme nach einem der Ansprüche 2 bis 4, dadurch gekennzeichnet, daß auf dem Isolator (11) eine Hybrid-Schaltung (1) angeordnet ist.

6. Klemme nach einem der Ansprüche 1 bis 5, dadurch gekennzeichnet, daß die Klemme als Normklemme ausgebildet ist.

7. Klemme nach einem der Ansprüche 1 bis 6, dadurch gekennzeichnet, daß die Klemme einen Sockel (17) mit Anschlußmitteln für die Befestigung auf einer Schiene, insbesondere einer Hutschiene aufweist.

8. Klemme nach einem der Ansprüche 1 bis 7, dadurch gekennzeichnet, daß das Verbindungsstück (4) einen vorgegebenen definierten Widerstand aufweist.

9. Gehäuse für die Aufnahme mehrerer Klemmen , dadurch gekennzeichnet, daß die Klemmen nach einem der Ansprüche 1 bis 8 ausgebildet sind.

10. Gehäuse nach Anspruch 9, dadurch gekennzeichnet, daß die Verbindungsstücke der Klemmen unterschiedliche Widerstände aufweisen.

## Claims

1. A terminal for connecting live conductors, comprising at least two terminal components (9) for the electrical conductors and a connecting piece (4) electrically interconnecting the terminal components (9), characterised in that the terminal has one or more magnetic field sensors (2) at a predetermined distance from the connecting piece (4) which produces the electrical connection between the terminal components (9).

2. A terminal according to claim 1, characterised in that one or more insulators (11) are arranged between the connecting piece (4) and the magnetic field sensor (2).

3. A terminal according to claim 1 or 2, characterised in that the insulators (11) interconnect the magnetic field sensors (2) and the connecting piece (4).

4. A terminal according to any one of claims 1 to 3, characterised in that an evaluation circuit (3) is provided in the terminal in addition to the magnetic field sensor (2).

5. A terminal according to any one of claims 2 to 4, characterised in that a hybrid circuit (1) is arranged on the insulator (11).

6. A terminal according to any one of claims 1 to 5, characterised in that the terminal is formed as a standard terminal.

7. A terminal according to any one of claims 1 to 6, characterised in that the terminal has a base (17) with connecting means for fastening to a rail, in particular a top-hat rail.

8. A terminal according to any one of claims 1 to 7, characterised in that the connecting piece (4) has a predetermined defined resistance.

9. A housing for holding a plurality of terminals, characterised in that the terminals are formed according to any one of claims 1 to 8.

10. A housing according to claim 9, characterised in that the connecting pieces of the terminals have different resistances.

## Revendications

1. Borne de liaison de conducteurs parcourus par du courant électrique, comportant au moins deux éléments de serrage (9) pour les conducteurs électriques et une pièce de liaison (4) reliant électriquement les éléments de serrage (9),
caractérisée en ce qu'elle présente un ou plusieurs détecteurs de champ magnétique (2) placés à une distance prédéfinie par rapport à la pièce de liaison (4) qui réalise la liaison électrique entre les éléments de serrage (9).

2. Borne suivant la revendication 1, caractérisée en ce qu'entre la pièce de liaison (4) et le détecteur de champ magnétique (2), sont disposés un ou plusieurs isolateurs (11).

3. Borne suivant la revendication 1 ou la revendication 2, caractérisée en ce que les isolateurs (11) relient entre eux les détecteurs de champ magnétique (2) et la pièce de liaison (4).

4. Borne suivant l'une des revendications 1 à 3, caractérisée en ce qu'en plus du détecteur de champ magnétique (2), il est prévu, dans la borne, un circuit d'interprétation (3).

5. Borne suivant l'une des revendications 2 à 4, caractérisée en ce que, sur 1' isolateur (11), est placé un circuit hybride (1).

6. Borne suivant l'une des revendications 1 à 5, caractérisée en ce qu'elle est réalisée sous la forme d'une borne normalisée.

7. Borne suivant l'une des revendications 1 à 6, caractérisée en ce qu'elle présente un socle (17) comportant des moyens de raccordement pour la fixation sur un rail, en particulier un profilé chapeau.

8. Borne suivant l'une des revendications 1 à 7, caractérisée en ce que la pièce de liaison (4) présente une résistance définie déterminée à l'avance.

9. Boîtier destiné à recevoir plusieurs bornes, caractérisé en ce que les bornes sont réalisées suivant l'une des revendications 1 à 8.

10. Boîtier suivant la revendication 9, caractérisé en ce que les pièces de liaison des bornes présentent différentes résistances.
